(19) **Europäisches Patentamt / European Patent Office / Office européen des brevets**

(11) **EP 4 575 642 A1**

(12) # EUROPEAN PATENT APPLICATION

(43) Date of publication:
**25.06.2025 Bulletin 2025/26**

(21) Application number: **23218034.9**

(22) Date of filing: **19.12.2023**

(51) International Patent Classification (IPC):
$G03F\ 7/20^{(2006.01)}$     $G03F\ 7/00^{(2006.01)}$

(52) Cooperative Patent Classification (CPC):
**G03F 7/70558; G03F 7/2014; G03F 7/202; G03F 7/2022**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Esko-Graphics Imaging GmbH 25524 Itzehoe (DE)**

(72) Inventor: **KLEIN, Thomas 8105 Regensdorf (CH)**

(74) Representative: **Jonas, Hans-Hermann X-Rite Europe GmbH Althardstrasse 70 8105 Regensdorf (CH)**

Remarks:
Claims 16 to 17 are deemed to be abandoned due to non-payment of the claims fees (Rule 45(3) EPC).

(54) **AUTOMATED PLATE RELIEF SETTING WITH UV LED EXPOSURE**

(57) Disclosed is a system and method for automatically calibrating back exposure settings for a batch of photopolymer printing plate precursors, each comprising a backing layer having an unknown concentration of actinic radiation (AR) blockers, a photosensitive polymer activated by exposure to AR, and a front mask layer. The method includes removing a portion of the front mask layer, positioning a photosensor on one side of the plate precursor aligned with the removed portion of the mask layer, exposing the plate to AR using a first setting, measuring the AR power that reaches the photosensor, comparing the measured AR power with a target AR power value expected to be received for the plate precursor, and calculating a second setting for the one or more radiation sources suitable to reach a desired floor thickness of a finished printing plate formed from the plate precursor receiving the actinic radiation from one or more radiation sources.

FIG. 1

EP 4 575 642 A1

**Description**

BACKGROUND OF THE INVENTION

Many processes are known in the art for preparing polymer printing plates, such as photopolymer flexographic plates and letterpress printing plates coated with photopolymer. One known process starts with a plate precursor having an ablatable material thereon, imaging the plate precursor in a digital imager to ablate the ablatable material according to imaging data, and then curing the exposed plate precursor by exposure of the plate to radiation, such as light energy, including but not limited to ultraviolet (UV) light energy.

Various processes for curing the plate precursor on both the imaged side and the back side of the plate by exposure to a functional energy source are known, including methods for providing a blanket exposure (such as with fluorescent light tubes that emit UV light), and methods for providing the desired radiation using light emitting diode (LED) technology, such as is described in U.S. Patent No. 8,389,203, assigned to the assignee of the present application and incorporated by reference. One particularly useful LED arrangement is shown and described in U.S. Pat. No. 8,578,854, also incorporated herein by reference.

Known processes include exposing the back of a plate precursor, then performing laser ablation on the front side of the plate precursor, then performing front side exposure. Other processes include laser ablating the front side of the plate precursor, then curing one side of the plate precursor using a blanket exposure, manually flipping the plate precursor, and then curing the other side of the plate precursor. Each of the foregoing processes interposes an undefined, variable time delay between the first and second exposure, depending upon the amount of time for the laser ablation step in the first process, or depending upon the time it takes to manually flip the plate precursor, in the second. This variability in elapsed time between first and second exposure leads to undesirable variability in finished plate quality. Still other processes may include exposing both the back side and the front side of a plate precursor simultaneously, which although it produces more predictable results than a process that imposes a variable time delay, is still not optimal. In the field of printing, minimizing the size of a dot printed on a substrate is desirable, but smaller dots correspond to smaller printing plate elements, which are more susceptible to damage during use. Accordingly, reducing the size of printed dots, while also providing optimal stability of the printing elements on the plate for making those printed dots, is desired.

Particularly useful methods and apparatus for exposing photosensitive printing plate precursors with a predetermined radiation density from the main side (top) and a predetermined radiation density from the back side (bottom) are shown and described in U.S. Pat. No. 10,732,507 and applications and patents related thereto ("the '507 patent family), also incorporated herein by reference. Namely, the method comprises executing the main exposure with a predetermined amount of time delay after the back exposure. The time delay between back exposure and main exposure is optimized to create smaller stable single dot elements on the photosensitive printing plate precursor after processing and smaller single element dot sizes printed on the print substrate. The plate floor may be adjusted by performing a back-side-only exposure prior to executing the combined back and main exposure with the time delay. As described in the '507 patent family, applying back exposure energy to the plate precursor rear side prior to the combined back-main exposure steps may be initiated to overcome challenges that arise with respect to curing photopolymer printing plate precursors having back sides that are less sensitive to UV radiation, such as may arise from relatively higher photo-blocker content in the plate precursor rear-side plastic substrate.

Those of skill in the art understand that a floor layer of a printing plate is created by exposing the opposite or back side of the polymer plate precursor through the polyester sheet to actinic radiation. Adjusting a thickness of the floor layer typically requires several steps, is time consuming, and must be done with every new batch of every plate type. For example, at least the following steps are required:

1. Place a plate precursor on the UV exposure device.

2. Remove a portion of mask to create an area of the printing surface by front side exposure.

3. Expose different backside sections of the plate precursor with different radiation intensities.

4. Process the plate precursor to form a finished plate (this includes removing non-cured polymer, drying, UVA and UVC aftertreatment.

5. Check the depth of the relief at the sections of different backside exposure.

6. Identify the backside intensity that produced the correct floor thickness and apply the intensity for future plate exposure.

Those of skill in the art also understand that oxygen is distributed throughout the photopolymer resin of a polymer plate precursor at the time it is typically processed, and that oxygen is an inhibitor of the polymerization reaction commonly harnessed for curing the plate precursors. Although polymerization caused by exposure of the polymer to actinic radiation scavenges this distributed oxygen, ambient oxygen will diffuse back into the resin over time if the plate precursor is in contact with atmospheric air. In the field of printing, the amount of exposure energy determines the thickness of the floor layer. The exposure time depends on the sensitivity of the polymer, which is determined by at least the concentration of photo-initiators in the polymer and the irradiance of the actinic radiation. However, the typically short duration of the required exposure time makes it challenging to provide an exact dose required to satisfy a target floor thickness.

Accordingly, typical flexographic photopolymer printing plates include UV blockers, which reduces the UV intensity and extends the required exposure time, thereby making it easier to determine the exact radiation dose for the target floor thickness. For example, the polyester sheet or layer of the printing plate typically contains a UV blocking chemistry. However, precisely controlling the blocking properties of said UV blockers pose challenges, and the required UV intensity may vary by up to a factor 2 from one plate batch to another. As a result, the required UV dose for a given target floor thickness can vary from one plate batch to another, thereby requiring control of the floor thickness based on one or more variables, e.g. types of plates, or new batch(es) of plates. Further, adjusting the floor thickness requires several steps and can be time consuming. One method of controlling the resulting floor thickness of the plates is by readjusting the back exposure UV-energy, such as by the method described in the '507 patent family.

Various processes comprising calibration of exposure from a radiation source, such as an LED array, include using one or more sensors to measure characteristics of the LED array, such as irradiation intensity, are known. For example, the '507 patent family mentions that characterizations and re-calibration of the LEDs may be performed on a periodic basis to account for variations in the LED array lines over time. Such characterizations may be performed by positioning a sensor that measures incident radiation at a predetermined distance from each line of LED sources. The '507 patent family notes that in addition to compensating for variations in the output intensity of the LEDs themselves, further compensations may be made for variations in transmissivity of any structure that lies between the sources and the printing plate precursor, such as for example, the glass surface that lies between the back sources and the printing plate precursor. Any characterizable variations in transmissivity of emitted radiation through the glass surface can be countered by varying the intensity of the LEDs based upon carriage location so that the amount of radiation that reaches the back of the plate is as close to homogenous as possible over the entire exposed plate precursor area.

U.S. Patent Application No. 17/626,849 (US Publication No. US20220276568A1) discloses an apparatus for exposure of a relief precursor, in which the apparatus includes an LED array configured to illuminate a photosensitive layer of the relief precursor and is comprised of a plurality of subsets of individually controllable LEDs and a control unit for controlling them, wherein the LED array is arranged to illuminate the photosensitive layer of the relief precursor through the substrate layer of the relief precursor.. However, the methods described therein relate to controlling the LED array to achieve a predetermined, e.g. homogeneous, irradiation pattern. For example, when the sensor detects that one of the LEDs is broken or worn, neighboring LEDs are controlled to compensate for the broken or worn LED.

It should be understood that the term "relief precursor" and "plate precursor" as used herein refer to an unfinished printing plate, whereas "finished printing plate" refers to a plate that is ready to accept ink in a printing step of a printing process. At times, the term "plate" may be used to refer to either a precursor or a finished plate (or both), the intended meaning of which will be clear to one of skill in the art based upon the context.

Thus, there is a need in the art to provide improved systems and methods for automatically calibrating UV back exposure settings for a batch of photopolymer printing plates having an unknown concentration of UV blockers.

BRIEF DESCRIPTION OF DRAWINGS

FIG. 1 depicts a printing plate in accordance with aspects of the invention;

FIG. 2 depicts a graph showing impacts on polymer transmissivity based on intensity of the exposure radiation in accordance with aspects of the invention;

FIG. 3 depicts a graph showing impacts on polymer transmissivity for front side and backside curing of plates comprising identical polymer, but different transmissivities of backing layers in accordance with aspects of the invention;

FIG. 4A depicts a schematic of a system for automatically calibrating UV back exposure settings for a batch of photopolymer printing plates in accordance with aspects of the invention, with the calibration photodetector positioned adjacent a front side of the plate to receive radiation from a back side source;

FIG. 4B depicts a plan view of a stacked arrangement of an exemplary back radiation source having a primary source and secondary sources of different sizes and intensities;

FIG. 4C depicts a plan view of a laterally-aligned arrangement of an exemplary back radiation source having a primary source and secondary source of different sizes and intensities;

FIG. 4D depicts an alternate schematic arrangement of the calibration photodetector adjacent a back side of the plate to receive radiation from a front side source for automatically calibrating UV back exposure settings for a batch of photopolymer printing plates in accordance with aspects of the invention;

FIG. 5 depicts a graph showing adjustments made to the exposure or radiation intensity of the backside source in accordance with aspects of the invention; and

FIG. 6 depicts a method automatically calibrating UV back exposure settings for a batch of photopolymer printing plates in accordance with aspects of the invention.

SUMMARY OF THE INVENTION

One aspect of the invention comprises a method for automatically calibrating back exposure settings for a batch of photopolymer printing plate precursors. Each plate precursor has a backing layer, a photopolymer layer comprising a photosensitive polymer activated by exposure to actinic radiation, and a front mask layer. The backing layer of plates in the batch have an unknown concentration of actinic radiation blockers. The method includes the steps of: (a) removing a portion of the front mask layer; (b) positioning a photosensor on one side of the plate precursor aligned with the removed portion of the mask layer; (c) exposing the plate precursor to actinic radiation from the side of the plate precursor opposite the photosensor, via one or more radiation sources operating at a first setting; (d) measuring the actinic radiation power (e.g. as irradiance -- power per unit of surface area) that reaches the photosensor through the plate precursor; (e) comparing the measured actinic radiation power (irradiance) with a target actinic radiation power (irradiance) value expected to be received for the plate precursor for the radiation source operating at the first setting; and (f) calculating from the measured actinic radiation power (irradiance) and the target actinic radiation power (irradiance) value a second setting for the one or more radiation sources suitable to reach a desired floor thickness of a finished printing plate formed from the plate precursor receiving the actinic radiation from the one or more radiation sources.

One aspect of the invention comprises a system for automatically calibrating back exposure settings for a batch of photopolymer printing plates. Each photopolymer printing plate precursor has a backing layer, a photopolymer layer, and a front mask layer, the backing layer of plates in the batch having an unknown concentration of actinic radiation blockers. The system includes: a plate holder configured to receive a plate precursor; one or more radiation sources including at least one front radiation source positioned to expose a front side of the plate to radiation, and at least one back radiation source positioned to expose a back side of the plate to radiation t; a photosensor positioned to receive actinic radiation from at least one of the one or more front and back radiation sources transmitted through a plate precursor disposed on the plate holder; a controller connected to the one or more front and back radiation sources, the controller configured to: commence irradiation of the plate precursor from a side of the plate opposite the photosensor; measure actinic radiation power (irradiance) that reaches the photosensor through the plate precursor; compare the measured actinic radiation power (irradiance) with a target actinic radiation power (irradiance) value expected to be received for the plate precursor irradiated with the at least one of the one or more front and back radiation sources with the system operating at a first setting; and calculating from the measured power (irradiance) and the target power (irradiance) value a second setting suitable to reach a desired floor thickness of a finished printing plate resulting from back exposure of the plate precursor with the system at the second setting.

DETAILED DESCRIPTION OF THE INVENTION

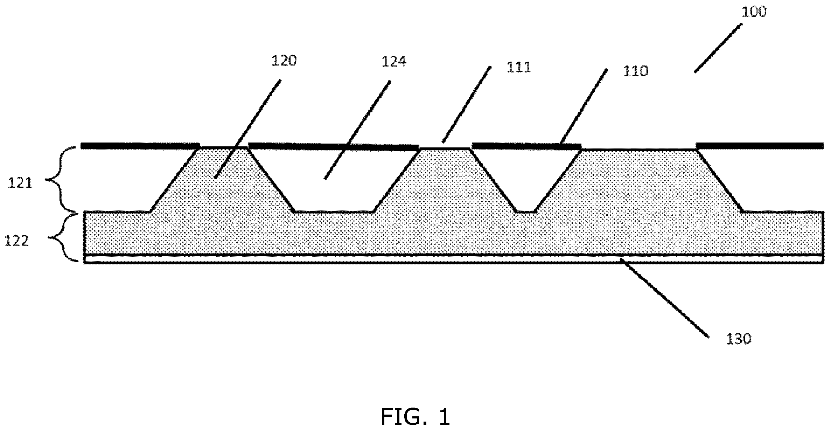

An exemplary plate photopolymer printing plate is depicted in FIG.1. In an exemplary embodiment, the printing plate comprises a digital printing plate, which includes a mask layer that transfers the image information to the polymer, e.g. a Laser Ablate-able Mask System (LAMS). Although the systems and methods for automatically calibrating UV back exposure settings for a batch of photopolymer printing plates having an unknown concentration of UV blockers are discussed throughout the specification in the context of digital printing plates, one skilled in the art would understand that the systems and methods are not so limited and can be applied for other types of printing plates, including analogue photopolymer printing plates that use a separate film placed on top of the plate.

As shown in FIG. 1, known processes start with a printing plate 100 having a photosensitive polymer activated by exposure to radiation, a non-printing back side, and a printing front side with a mask 110 for defining an image to be printed.

The printing area includes relief structures, which may be formed via transfer of image information onto an imageable layer and removing parts of the imageable layer. In this way, the formed relief structures include elevated structures 120 used to carry and transfer the image information to a printing substrate. The elevated structures 120 are created by curing portions of the plate 100 by exposure of the plate 100 to radiation, such as light energy, including but not limited to ultraviolet (UV) light energy, e.g. UVA radiation of approximately 365 nm. The radiation is transmitted through the plate from the printing front side via openings 111 of the mask 110. Between these elevated structures 120 are non-elevated structures 124 which represent non-printing areas of the plate. On an opposite non-printing back side of the plate is a support layer 130, such as a polyester sheet (e.g. Mylar® brand), that provides dimensional stability for the polymer plate. Below the relief structure is a solid layer or floor 122 having a thickness that defines a height of the elevated structures and serves as a cushion or support for the elevated printing structures when pressure is applied (e.g. in a press). The floor layer 122 is typically created by exposing the opposite or back side of the polymer plate through the polyester sheet to actinic radiation.

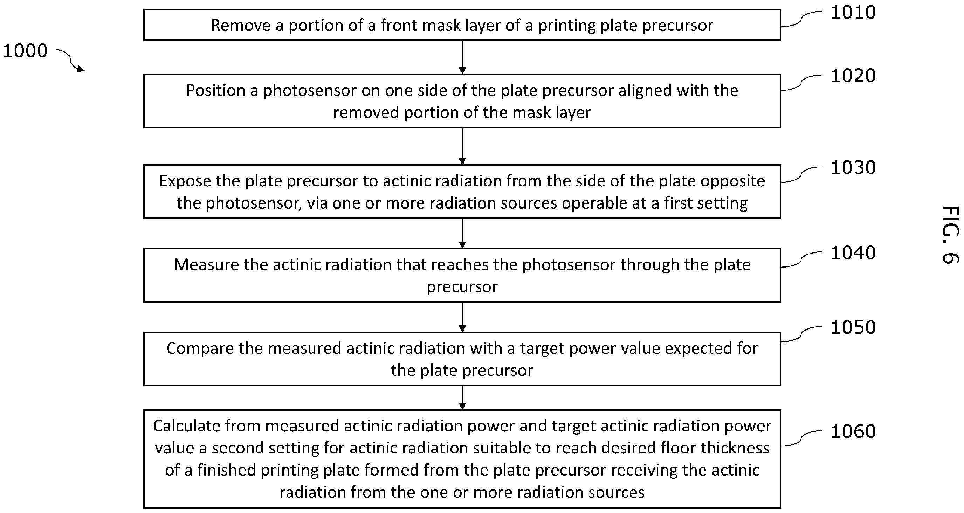

Referring now to FIG. 6, a method 1000 for automatically calibrating back exposure settings for a batch of photopolymer printing plate precursors is disclosed. Each plate precursor of the batch has a backing layer, a photopolymer layer comprising a photosensitive polymer activated by exposure to actinic radiation, and a front mask layer. The backing layer of plate precursors in the batch has an unknown concentration of actinic radiation blockers. Additional details of the method 1000 is discussed below in the context of a system 4000 for automatically calibrating back exposure settings for a batch of photopolymer printing plate precursors. Generally, the system 4000 includes a plurality of photopolymer printing plate precursors, such as plate 100, one or more radiation sources, and a controller connected to the one or more front and back radiation sources.

As is well known in the art, printing plate precursor 100 comprises a photosensitive polymer activated by exposure to actinic radiation, on which is disposed a mask 110 that defines portions of the plate precursor that are masked from radiation exposure relative to portions of the plate precursor that are desired to receive such exposure (e.g. via openings 111). In a typical embodiment, the polymer, including in the mask 110 area, is permeable to oxygen. In at least some exposure systems, one or more radiation sources, such as a UV source of actinic radiation with a predetermined power density (irradiance), is scanned at a specific speed (v) under the bottom of the plate 100. For the main or front exposure of the photosensitive printing plate 100, a second UV source of radiation with a predetermined power density (irradiance) is scanned above the plate with the same specific speed (v). Further sources of actinic radiation are configured to scan the printing plate with the same speed (v). Such a configuration may be provided by synchronizing the actinic radiation sources to have a same speed using a controller, or both sources may be attached to a common carriage that traverses the plate, with said actinic radiation sources being spaced apart from one another a suitable distance in the direction of carriage travel to provide the desired delay when the carriage moves at a predetermined speed. The predetermined irradiance may be the same for the main side and the back side, or may be different. Preferably the irradiance at the rear side is only a fraction of the irradiance of the front side exposure. Typically, the irradiance at the rear side is in a range of 10% or less of the front side irradiance, but the invention is not limited to any particular ratio of front to back irradiance. The predetermined irradiance is typically a function of the characteristics of the specific type of plate to be exposed, as is known to those of skill in the art, and as is dictated by the manufacturers of such plates.

Due to the typical combination of large area light sources and small area detectors, relevant power measurements are typically dependent on the size of the detector area. Accordingly, the power of large area sources is typically measured and expressed in power per unit of surface area, also referred to as irradiance. Accordingly, as used herein, it should be understood that the terms "power" and "irradiance" may be used interchangeably or in the alternative, with irradiance considered one non-limiting (albeit most commercially practical) way in which to express a measurement of power. The invention is not limited to any particular way to measure of express power, however.

The relative movement between the radiation sources and the plate may be provided by any mechanism known in the art for moving objects relative to a horizontal, vertical, or otherwise disposed stationary surface. For configurations in which the radiation sources move and the plate is stationary, for example, the sources may be disposed on a gantry system having arms that pass the respective sources above and beneath a stationary horizontal plate mounted on a substrate configured to permit a sufficient amount of radiation to pass through, or on either side of a vertically mounted plate. For configurations in which the radiation sources are stationary and the plate is movable, for example, the plate may be mounted on any mechanism known in the art, such as a movable stage configured to move relative to fixed sources on opposite sides of the stage. Mechanisms for rotating a cylinder on which a plate is mounted relative to fixed sources are well known in the field of printing. Similarly, mechanisms for rotating sources relative to a fixed cylinder on which a stationary object is mounted are also well known, such as in the field of medicine (e.g. CAT scan machines). Thus, mechanisms for moving one or more elements relative to another are well known in the art, generally, and the invention is not limited to any particular mechanism.

In an exemplary embodiment, a printing plate precursor, such as plate 100 or 430, includes a backing layer 130, a photopolymer layer comprising a photosensitive polymer activated by exposure to actinic radiation, and a front mask layer 110. The backing layer 130 (e.g. polyester) of plate precursors 100/430 in the batch has an unknown concentration of actinic radiation blockers. Referring to FIG. 1, formed relief structures on plate 100 include elevated structures 120 used to carry and transfer the image information to a substrate (not shown), and non-elevated structures 124 which represent non-printing areas of the plate 100.

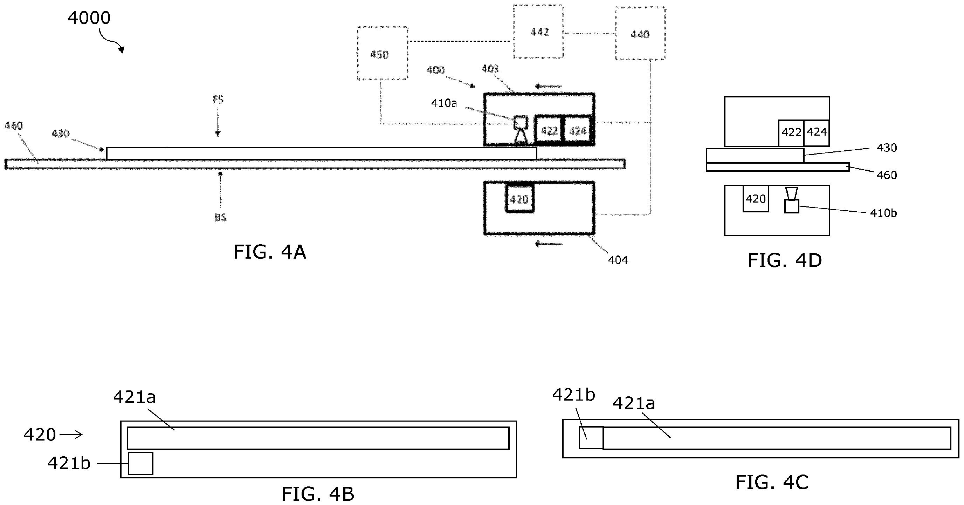

As shown in FIG. 4A, an exemplary system 4000 includes an exposure device 400 having one or more radiation sources, such as one or more actinic radiation sources. In an exemplary embodiment, the one or more actinic radiation sources include at least one front source positioned to expose a front side of the plate and at least one back source positioned to expose the back side of the plate. For example, the exposure device 400 has at least one exposure apparatus 403 comprising at least one back or backside (BS) radiation source 420 and the front or frontside (FS) actinic radiation sources 422 and 424. In one example, backside radiation source 420 provides sufficient intensity above 100 mW/cm$^2$ or more preferably, above 300 mW/cm$^2$. When the backside radiation source 420 has a lower radiation intensity, such as 20 mW/cm$^2$, the radiation intensity that reaches the photosensor or detector 410a (discussed below) will be very low and the signal to noise ratio will be poor. In such cases, it may be preferable to use, if applicable, a higher radiation output from another of the radiation sources, such as the front exposure source 422, 424 directed to photosensor 410b (positioned adjacent the back side of the plate as depicted in FIG. 4D) to detect and measure a reasonably strong signal from the opposite side of the plate 430. The backside exposure via BS radiation source 420 is desirable because the attenuation of the backing layer 130 reduces the increase in polymer transmissivity and allows more time for the measurements (as discussed further below). The entire device 400 can be moved in direction of the arrow along the plate 430 which resides on a support surface 460.

It should be understood that in the embodiment depicted in Fig. 4A, each of the front source 422, 424 and the back source 420 have an irradiation field covering an area at least coextensive with a width of the plate but not coextensive with a full length of the plate. Each of the front source and the back source may thus comprise a linear source that emits radiation along a line parallel to the width of the plate. Each linear source, however, may comprise a plurality of subsources that together collectively create the linear radiation field having a defined length less than the length of the printing plate, and a width that spans at least the entire width of the printing plate.

Relative movement between the plate 430 and the radiation sources is triggered by a drive mechanism 440 controlled by a controller/control system 442. In one embodiment, the plate 430 is fixed and the drive mechanism 440 moves the housing units 403/404. In another embodiment (not shown), the housing units 403/404 are fixed and the drive mechanism 440 moves plate 430. Housings 403 and 404 may be attached to a common carriage that traverses the plate 430. Although, multiple front side curing radiation sources 422, 424 are shown, other embodiments may have only a single curing source on the front side. In applicable embodiments, sources 420 and 422 are spaced apart from one another a suitable distance in the direction of carriage travel to provide a desired delay when the carriage moves at a predetermined speed. Likewise, although only a single back side curing radiation source 420 is depicted, other embodiments may have multiple back side curing sources, as described further herein.

Processor 450 may be coupled to the photodetector 410 via any type of data interface known in the art. Although depicted separately, processor 450 may be embedded in or part of controller 442, and is preferably at least in communication with controller 442. Processor 450 (and control system 442) may be located inside or outside of housing 403 (or 404). Processor 450 receives information from the photodetector 410 relating to the irradiance received through the plate 430 during the calibration step. Processor 450 processes the information and provides an interpretation of the results based on the processed information, as described in greater detail herein below. Control system 442, including processor 450 is configured to commence irradiation of the plate precursor from a side of the plate opposite the photosensor; measure actinic radiation power that reaches the photosensor through the plate precursor; compare the measured actinic radiation power with a target actinic radiation power value expected to be received for the plate precursor irradiated with the at least one of the one or more front and back radiation sources with the system operating at a first setting; and calculate from the measured power and the target power value a second setting suitable to reach a desired floor thickness of a finished printing plate resulting from back exposure of the plate precursor with the system at the second setting.

Other configurations of the components of the system 4000 are shown and described in EP Patent No. 3794411B1, herein incorporated by reference for all purposes, wherein the printing plate comprises a Laser Ablative Mask System (LAMS) plate having a laser ablatable layer disposed on a front side of the plate, and the process for preparing the polymer printing plates includes imaging the plate in a digital imager using a modulated laser beam to ablate the LAMS layer according to imaging data to create a mask, and then curing the exposed plate by exposing the plate through the LAMS layer mask to actinic radiation, including but not limited to radiation in the ultraviolet (UV) wavelength range.

In step 1010, a portion of the front mask layer is removed. For example, with reference to FIG. 1, a portion of the front mask layer 110 is removed to form one or more openings 111 in front mask layer 110.

In step 1020, a photosensor on one side of the plate precursor is aligned with the removed portion of the mask layer. For example, as shown in FIG. 4, a photosensor 410 is positioned on one side of plate precursor 430, such that the photosensor 410 is in alignment with the removed portion of the mask layer (e.g. openings 111). In still other embodiments, the photosensor 410 comprises plural photosensors 410, each positioned a lateral distance relative to each other and on one side of the plate 430 aligned with the removed portion of the mask layer 110. Generally, the photosensor 410 is configured to measure one or more characteristics related to the light or actinic radiation source, such as UV power or radiation intensity. This value may be e.g. a UV light intensity (in mW/cm2) and/or a total amount of UV radiation during a specified time period or duration of exposure, for example. Other suitable sensors or combinations thereof will be readily understood by one skilled in the art.

It should be understood that the arrangement depicted in FIG. 4 is schematic in nature only, to show the relationship among the components of system 4000, such as between the photosensor 410 and their distance relative to a plate 430. Furthermore, although shown in a flat orientation, the printing plate may be flexible enough to be disposed around a transparent cylinder, such as a glass cylinder, or the plate may be in the form of a continuous sleeve, as is known in the art, with the distances between the light sources arranged relative to the rotational direction of the cylinder.

In step 1030, the plate precursor is exposed to actinic radiation from the side of the plate precursor opposite the photosensor, via one or more radiation sources operating at a first setting. For example, as depicted in Fig. 4, plate 430 is exposed to UV exposure from BS radiation source 420 from the side of the plate 430 opposite the photosensor 410. In one work flow configuration, plate 430 is exposed to UV exposure via the one or more radiation sources 422, 424, 420 over a total plate exposure time ($tc$).

Additionally, or optionally, during a normal curing operation, plate 430 is exposed to UV exposure via each of the one or more actinic radiation sources (e.g. back source 420) having respective normal curing exposure intensities over a normal total plate exposure time (tc). In this embodiment, in a step for gathering calibration information, the plate is exposed to UV exposure via the at least one back radiation source 420 having a calibration back-side-only exposure intensity that is higher than the normal curing exposure intensity for a calibration exposure time that is shorter in duration than the normal curing exposure time (tc). In other words, the calibration intensity may be a comparatively short, high-intensity flash of radiation, as compared to normal curing radiation. Normal curing radiation time, depending on the plate type and blocking properties of the support layer 130, can add up to several minutes. Thus, for example, the comparatively short, high-intensity flash of radiation is applied for a duration of less than 1 second, and may be as short as a few milliseconds. Still further, in one example, the back-side-only exposure is applied (via the back radiation source 420) only to an opening 111 of the front mask layer 110 created in or by step 1010. Alternatively, the back-side-only exposure (via the back radiation source 420) is applied to an entirety of a surface of the plate precursor 430.

Specifically, in certain embodiments, in which the backside radiation source can provide a sufficient intensity (e.g. above 100 mW/cm$^2$, or more preferably above 300 mW/cm$^2$), backside exposure for calibration may be preferred because the attenuation of backing sheet reduces the increase in polymer transmissivity and allows more time for the measurements. In embodiments in which the backside radiation source has only a relatively low radiation intensity (e.g. on the order of 20 mW/cm$^2$), the radiation intensity that reaches the detector will be low and the signal-to-noise ratio may be less than ideal. In this case it may be preferable to use, if applicable, the higher radiation output of the front exposure source to get a reasonably strong signal for the sensor on the opposite side of the plate.

In still another exemplary embodiment, step 1030 is performed for a predetermined period $tm,$ and the predetermined period $tm$ is less than the total plate exposure time ($tc$). In a preferred embodiment $tm$ is less than 10 seconds, and more preferably, $tm$ is less than 1 second.

The overall mechanism for creating the exposure may comprise one or more radiation sources (e.g. banks of LED point sources, optionally mounted inside a reflective housing) mounted on a gantry system or carriage. The radiation sources are connected to a power source, such as an electrical power cord having sufficient slack to extend the full range of motion of the carriage. The carriage may be moved by any drive mechanism known in the art (also coupled to the power supply and the controller), including a chain drive, a spindle drive, gear drive, or the like. The drive mechanism for the carriage may comprise one or more components mounted within the carriage, one or more components fixed to the table, or a combination thereof. A position sensor (not shown) is preferably coupled to the carriage to provide feedback to the controller regarding the precise location of the carriage at any given time. The control signal output from the controller for operating the radiation sources and for controlling motion of the carriage may be supplied via a wired or wireless connection. The controller may be mounted in a fixed location, such as connected to the table with a control signal cable attached to the sources similar to the power cable, or may be mounted in or on the carriage. The control system and drive mechanism cooperate to cause back/forth relative motion in a transverse direction between the light from the radiation sources and the plate. If should be understood that other embodiments may be devised in which the drive mechanism is configured to move the portion of the table containing the plate past stationary upper and lower linear radiation sources, as well as embodiments in which the radiation sources cover less than the full width of the plate and are movable in both the transverse and longitudinal direction to provide total plate coverage (or the plate is movable in both directions, or the plate is movable in one of the two directions and the sources are movable in the other direction to provides the full range of motion required to cover the entire plate).

As discussed in U.S. Pat. No. 8,578,854, each bank of LED sources may comprise a plurality of discrete units having a plurality of individual LED point sources on each unit, with the plurality of point sources arranged in a plurality of lines. All of the point sources on each unit may be controlled together, may be individually controlled, or may be controlled in groups. For example, each line of point sources in each unit (e.g. each of lines) may be separately controllable. Providing such a fine level of control may have several advantages. For example, the actual output from each line of LEDs may vary slightly for the same amount of input energy, due to variations in the LEDs themselves, soldering to the circuit board, cooling, decay or wear over time, and the like, and thus, each line of LEDs may be characterized and their intensity varied by an appropriate factor relative to other lines to so that the radiation output produced by each line is as close to homogenous as possible. Characterizations and re-calibration may be performed on a periodic basis to account for variations in the lines over time. Such characterizations may be performed by positioning a sensor that measures incident radiation at a predetermined distance from each line of LED sources. On top of compensation for variations in the output intensity of the LEDs themselves, further compensations may be made for variations in transmissivity of any structure that lies between the sources and the printing plate, such as for example, the glass surface that lies between the back sources and the printing plate. Any characterizable variations in transmissivity of emitted radiation through the glass surface can be countered by varying the intensity of the LEDs based upon carriage location so that the amount of radiation that reaches the back of the plate is as close to homogenous as possible over the entire exposed plate area.

In step 1040, the actinic radiation power (irradiance) that reaches the photosensor through the plate precursor is measured. In an exemplary embodiment, the photosensor 410 is configured to measure the UV power (irradiance) transmitted through plate 430, from the one or more radiation sources (e.g. BS radiation source 420). Additionally, or optionally, the measurement is executed with a comparatively short, high-intensity flash of radiation, as compared to normal curing radiation, via a back-side-only exposure using the back radiation source 420 having an intensity that is significantly higher than the intensity used for normal curing radiation. For example, this short, high-intensity flash of radiation is applied only to a portion of the plate precursor 430, such that the short, high-intensity flash of radiation is transmitted through the plate precursor 430 via openings 111 of the mask 110. In one example, this portion of the plate precursor 430 is located in a portion of the plate comprising a non-printing area of the plate or a plate patch. Alternatively, the short, high-intensity flash of radiation can be applied to an entirety of the plate precursor 430.

In an exemplary embodiment, in the case of analogue plates, which use a separate film instead of the LAMS, the film remains on the plate precursor 430 during performance of step 1040. Alternatively, the film comprises one or more non-blackened spots, where the actinic radiation power (irradiance) that reaches the photosensor through the plate precursor 430 is measured.

In step 1050, the sensed or measured actinic radiation power (irradiance) is compared with a target actinic radiation power (irradiance) value expected to be received for the plate precursor from the radiation source operating at the first setting. In an exemplary embodiment, the actinic radiation power (irradiance) measured or sensed by photosensor 410 is compared with a target actinic radiation (irradiance) power value expected for plate 430.

In step 1060, a second setting is calculated for the actinic radiation power suitable to reach a desired floor thickness of a finished printing plate formed from the plate precursor receiving the actinic radiation from the one or more radiation sources. For example, the second setting comprises an exposure intensity setting for the one or more actinic radiation sources, such as the BS radiation source 420. In an exemplary embodiment, the exposure intensity setting is calculated as a factor to be applied to a first exposure intensity setting calculated to reduce a difference between the measured actinic radiation (irradiance) power and the target actinic radiation power (irradiance).

In an exemplary embodiment, step 1060 comprises adjusting the floor thickness of the finished printing plate 430 formed from the plate precursor receiving the actinic radiation from the one or more radiation sources 422, 424, 420. In an exemplary embodiment, the floor thickness is adjusted by providing one or more back-side-only exposure steps, each back-side-only exposure step comprising providing relative movement between the plate 430 and the irradiation field from the one or more actinic radiation sources, such as the BS radiation source 420. In another exemplary embodiment, when photosensor 410 includes plural photosensors 410, step 1060 includes calculating an average correction factor suitable to reach the desired floor thickness of the printing plate 430 resulting from back exposure based on the measured power (irradiance) from the plural photosensors 140.

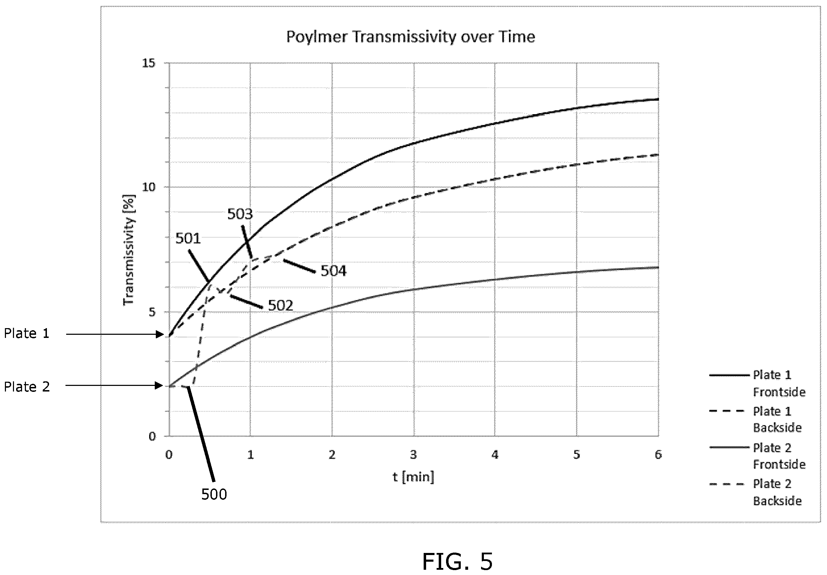

In an exemplary embodiment, when consecutive individual measurement steps 1040 are repeated for a predetermined number of times, each measurement step is subsequently followed by a compensation or correction step that adjusts the exposure or radiation intensity of the backside source 420 until the measured radiation intensity follows the expected curve for the plate 430. As shown in FIG. 5, four correction steps, each resulting in a subsequent measurement value 501 - 504 obtained following an initial measurement 500, were made such that the curve of "Backside Plate 2" follows exactly the curve of "Backside Plate 1". Ideally, during a multi-measurement calibration step as depicted in FIG. 5, the position of the plate, source, and detector remain stationary so that the multiple measurements are precisely taken in the same location on the plate, such that the measurement taken after each correction properly reflects the transmissivity corresponding to the degree of polymerization proportional to the cumulative radiation received in that spot prior to the measurement. Thus, in step 1060, the second setting calculated for the actinic radiation power (irradiance) comprises an exposure intensity of the at least one back radiation source 420, such that the difference between radiation intensity between the measured power (irradiance) and the target power (irradiance) value is reduced. Additionally, or optionally, after performing steps 1040-1060 or sets thereof, method 1000 includes commencing irradiating the front side of the printing plate.

In another exemplary embodiment, the measurement is executed with short flash of backside radiation having an intensity that is significantly higher than the intensity used for curing. This flash can be applied only to the portion of the plate where the mask opening for this measurement is located. Alternatively, the flash can be applied to the entire plate.

DETERMINING OPTIMAL MOMENT TO PERFORM A COMPARISON IN TRANSMISSIVITY MEASUREMENT

The inventors performed assessments of to evaluate and/or validate improvements discussed herein with respect to the system and method of automatically calibrating UV back exposure settings for a batch of photopolymer printing plates having an unknown concentration of UV blockers.

As described above, photo polymer printing plates typically need UV exposure from the front side and the back side. The front side exposure is applied through the mask, which holds the image information to be transferred to the printing plate. The rear side is exposed to UV radiation through the rear side plastic substrate without any vignetting in order to build a polymerized support layer over the entire plate for the fine printing details located on the plate's front side. This polymerized support layer is called the "floor." The floor thickness determines the relief depth for a given plate thickness.

Recent advances in technology for curing of photopolymer printing plates with UV light has produced a variety of LED-based exposure units from various suppliers. These units comprising LED UV light sources are increasingly replacing so-called "bank" exposure devices that incorporate fluorescent tube technology, in which light from the fluorescent tubes typically covers the complete plate surface at one time. Because LEDs are more expensive and require more complex driver electronics, while delivering a much higher UV power-per-unit-surface-area than fluorescent tubes, many embodiments comprise a light source that covers only one dimension of the polymer plate completely (e.g. width), while using relative motion between the plate and UV head to cover the second dimension (e.g. length), to ensure all surface areas of the plate are exposed to the UV light.

A standard exposure process comprises at least two exposure steps, wherein in each step the exposure heads move from a start position along the polymer plate, exposing the plate to actinic UV radiation with constant speed V in one direction, and afterwards returning in the opposite direction to their start position without emitting radiation in the return pass. During this process, in accordance with aspects of the invention described herein, the back exposure is applied to the polymer plate before the main exposure by a precisely determined time difference. Accordingly, the back exposure head moves a constant distance in advance of the main exposure head during polymer plate exposure, causing a constant delay time between rear and front exposure. The distance between main UV heads and back exposure head, and consequently the delay time, is typically adjustable.

As described herein, effective exposure time is determined by UV output aperture of the UV heads in traveling direction, the speed by which the heads travel along the polymer plate and the number of passes the head moved along the plate. The dimension of the UV output aperture in the direction of travel divided by the traveling speed results in the time per pass that a pixel in the plate "sees" UV light. This time is called "pixel time" in the following text.

The intent of the foregoing method is to obtain a cure of the polymer plate that is superior to a simple front and backside exposure applied without an elaborately coordinated timing sequence as described herein. Calibration as described herein is based on a sensed power (irradiance) value and target power (irradiance) value for adjusting the actinic radiation power (e.g. UV power or irradiance) suitable to reach a desired floor thickness of the printing plate resulting from back exposure. "Superior" in this case means the plate holds smaller printing details, which are fixed to the plate floor with higher stability and that do not bend during printing. Producing smaller print dots enables production of lighter highlights in the print.

The back exposure energy is increased or decreased to adjust the floor thickness of the plate. This can be done either by adjusting the irradiance of the back exposure UV head, by adjusting the pixel time, or by adjusting both pixel time and irradiance. Where the irradiance of the back exposure head cannot be increased any further, absent some other remedy, the UV output of the back exposure would have to be set to maximum and the pixel time increased to reach the required floor thickness (with some corresponding change to the front exposure to adjust for the increased time). This approach may affect the quality of the front exposure curing result, and thus, it may be necessary to evaluate the complete set of exposing parameters to maintain desirable plate printing quality.

Alternatively, the number of exposure cycles may be increased until the accumulated rear side exposure energy is sufficient to cure the plate floor to the required thickness. But this approach will also increase the front exposure energy, leading to higher energy input if the front exposure irradiance stays the same as before the increase in the number of cycles, which may lead to different curing and printing results. Also, if the irradiance of the front exposure is reduced to maintain the front exposure energy the same as before the increase of the number of exposure cycles, this may lead to different curing and printing results, making this an imperfect solution.

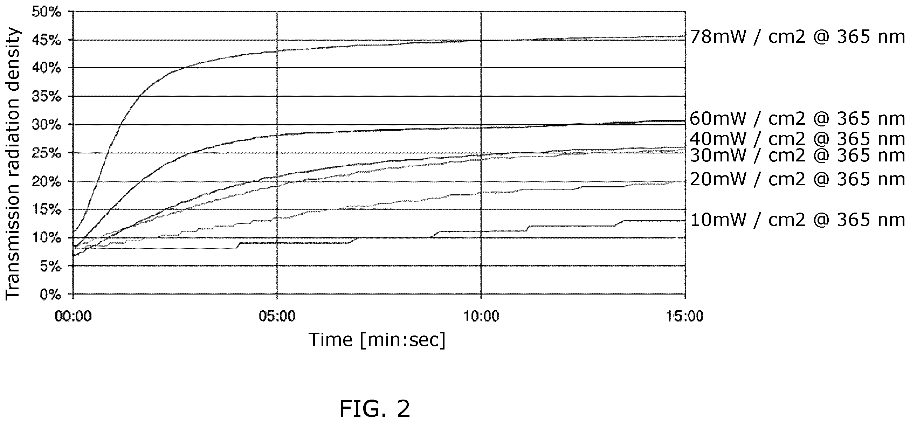

As is known to those of skill in the art, photo-initiators in the plate absorb parts of the UV radiation and are consumed during curing over time, the UV transmissivity of the plate increases following an exponential function over time. Furthermore, as depicted in FIG. 2, the intensity of the exposure radiation has some impact on the length of the polymer chains, thereby also changing the transmissivity of the polymer. Low intensities will produce shorter chains, whereas higher intensities longer chains. Short polymer chains have higher absorption than long chains. In particular, FIG.2 shows a measurement of the change of polymer transmissivity over time while the plate was exposed to different intensities of UV light at 365 nm. For this example, a Model No. DPR 045 printing plate, manufactured by DuPont, was used.

Thus, it is assumed that the different results for end transmissivity for different curing intensities depend on the different length of polymer chains. The length of the polymer chains is determined by the chain termination by oxygen during the curing process. As the oxygen has only a limited mobility inside the polymer only a certain ratio of chain terminations per time unit can occur within a given polymer volume. The higher the curing intensity, the faster all polymer is cured completely and the longer the cured polymer chains will be. Longer polymer chains are more transparent for UV Light than shorter polymer chains.

Furthermore, the complete curing of a given polymer volume takes longer when using a low intensity while complete curing is accomplished in a shorter period when using a higher intensity. As shown in FIG. 2, the high intensity curves reach an asymptotic course much earlier than low intensity curves. The change in transmissivity makes it more difficult to determine the correct compensation for the backside exposure dose. Moreover, the curing sometimes is executed in multiple consecutive backside-frontside combinations, which makes the function that describes the change of transmissivity more complicated and results less predictable. Accordingly, it was found to be best practice to start exposure with a back-side-exposure step, because this provides optimal curing result to produce the smallest possible printing details on the plate. Small printing details are desirable because they are required for smooth highlight fade outs in the print.

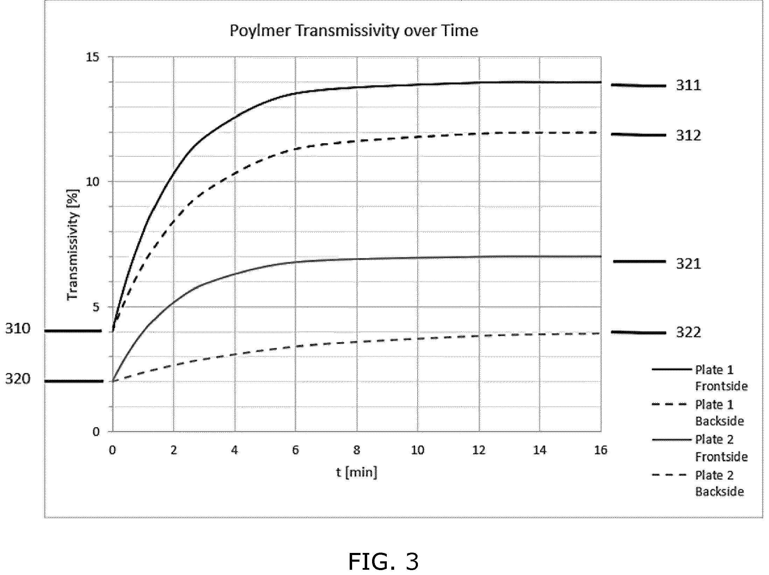

Still further, the polyester backing layer (layer 130), such as Mylar® sheets, can have different degrees of transmissivity, creating another variable to be considered. As mentioned above, the backing layer 130 comprise UV blocker molecules that reduce the curing speed of the plate floor in order to make the adjustment of the plates floor thickness more precise. Known backing layers include the UV blocker component(s) either added directly to the polyester material of the film or in the form of a primer that is located between the film and the photopolymer. In addition, for different batches of a type of printing plate, the transmissivity of for backside radiation can also vary by up to a factor of 2. These variations lead to a situation as depicted in FIG. 3, where two different transmissivities of a polymer plate are visualized in principle. The curves do not refer to a particular plate type, but solely show the principle change of transmissivity for two plates having the same polymer type but different transmissivity of the backing sheet 130.

As shown in FIG. 3, the % readings in the diagrams vertical scale present the signal of a sensor (e.g. radiation sensor) that is located opposite of the radiation source. The 100 % transmissivity does only occur when no plate is present between sensor and UV radiation source. When a plate is present, the initial transmissivity 310 and 320 is close but not identical to zero, depending on the combined absorption of the backing ® sheet 130 and the photopolymer.

As soon as actinic radiation is propagating through the plate, the transmissivity starts increasing towards an end value due to the reduction of photo initiators inside the polymer and the conversion of monomer particles into polymer chains. Once the photopolymer is cured completely, the transmissivity stops increasing. The end value usually is not 100% because the absorption of the backing sheet 130 remains unchanged, and the polymer transmissivity is usually below 100% depending on the chain length of the cured polymer. Hence, as shown in Equation 1 below, the transmissivity T as a function of the time $t$ is defined by two terms:

1. the constant absorption $Am$ of the backing (e.g. Mylar® polyester) sheet.

2. the time $t$ and intensity-depending absorption $Ap$ of the photopolymer, which changes over time from a starting value $Ap start$ to an end value $Ap end$ after all photo-initiators have been used up.

$$\text{Equation (1)} \qquad T(t) = Am * Ap(t)$$

The polymer transmissivity changes over time from a starting value $Ap\ start$ to an end value $Ap\ end.$ In first approximation the change over time can be calculated by :

$$\text{Equation (2)} \qquad T(t) = Am * \left[ Apstart + Ap\ end * \left( 1 - \frac{1}{e^{(t*Polym)}} \right) \right]$$

Equation (2) describes the situation where the curing radiation enters the polymer from the front side. The term *Polym* stands for the oxygen concentration respectively for the number of polymer chains that can be terminated within a certain time period. In this simplified model, this can be seen as the quantity of polymer chains that are terminated per second at the beginning of the curing process.

Depending on whether the light comes from the front or backside the increase of the transmissivity is faster for frontside exposure or slower when the radiation enters from the backside trough the backing sheet that reduces the exposure intensity. In this case the Term *Polym* must be multiplied with the transmissivity *Am * k* of the backing sheet to consider the slower progress of the curing due to the reduced exposure intensity, whereas k is a factor that accounts for the strength of the damping effect of *Am.*

$$\text{Equation (3)} \qquad T(t) = Am * \left[ Ap\ start + Ap\ end * Am * k \left( 1 - \frac{1}{e\left(t * Polym * Am * k\right)} \right) \right]$$

These functions do provide only a basic model of the change in transmissivity over time for a complete, uninterrupted curing of the polymer either form front or from back side.

As a result, the curves denoted as "Frontside" and "Backside" in FIG. 3 can be computed, similar to the measurements presented in FIG. 2. Each curve in FIG. 3 shows the change of transmissivity for a frontside only exposure or a backside only exposure. In other words, each curve in FIG. 3 illustrates the total curing of the polymer is completely and without interruption applied from one side only. These calculated curves show different progressions of the transmissivity for front side and backside curing of two different plates, Plate 1 and Plate 2, having identical polymer but different transmissivity of their polyester sheets. Plate 1 has an assumed polyester backing sheet transmissivity of 20% and another 20% polymer starting transmissivity which results in a total transmissivity at starting point 310 of 4%. For front exposure the transmissivity propagates towards an end point 311 of 14%. When exposed from the backside, the end transmissivity point 312 is 12%. Plate 2 has a different polyester backing sheet which has only 10% transmissivity which results in combination with the same polymer to a starting transmissivity point 320 of 2%. After this transmissivity has increased due to the curing the end transmissivity point 321 will reach 7% for front exposure and respectively 4% for the backside curing. Thus, it is apparent that the optimal moment to perform a comparison in transmissivity measurement for two polyester sheets is close to t=0.

Measurements taken in this first moment of polymerization (t=0) with various types of photopolymer plates have been made and are displayed in Table 1 below. The results in Table 1 indicate that the absolute intensity transmitted through the plate at the beginning of the exposure step is fairly low.

**Table 1: Transmissivity Measurements for Various Plate Types**

| Plate Type | Sensor signal without plate [mW/cm$^2$] | Sensor signal with Mylar® sheet only [mW/cm$^2$] | Sensor signal with Mylar® sheet and Photopolymer [mW/cm$^2$] |
|---|---|---|---|
| DuPont- DPR 045 | 130 | 15.5 | 1.7 |
| MacDermid - ITP-60 045 | 130 | 5.1 | 0.9 |
| XSYS - ACE 045 | 130 | 25.7 | 1.7 |

Therefore, depending on the type of exposure apparatus or configuration, in some cases it can be more advantageous to use the frontside exposure unit as the radiation source for calibration (as depicted in the arrangement of FIG. 4D) because the front side exposure unit delivers a higher radiation intensity compared to the back side radiation source.

In still other embodiments, such as depicted in FIGS. 4B and 4C, back exposure source 420 may include, in addition to the normal (first) back exposure light source 421a having a first area and first irradiance configured for curing the plate, a second light source 421b having a second (smaller) area and second (greater) irradiance located opposite front side detector 410 configured for use during the calibration operation as described herein. Preferably, second back side light source 421b has spectral properties identical to the first back exposure light source 421a to avoid different transmission properties through the backing sheet due to the spectral properties of the UV blocker. Although depicted with the first source 421b aligned behind or in front of the second source 421a in the travel direction of source 420 in the stacked arrangement of FIG. 4B, the first source 421a and second 421b source may be laterally aligned with one another along with width of the plate as depicted in FIG. 4C, wherein second source 421b may preferably align with a waste area of the plate, and the first source 421a aligns with a print-producing area of the plate. Or, in the laterally-aligned arrangement, second source 421b may be configured to operate at both the first (relatively lower) irradiance predetermined to be suitable or optimal for curing and the second (relatively higher) irradiance predetermined to be suitable or optimal for calibration, with controller 442 configured to operate second source 421b at the first irradiance during a curing opeartion and the second irradiance during a calibration mode. The arrangement of FIG. 4C uses less space that the arrangement of 4B, and provides the advantage of a having the relatively higher irradiance available for the calibration step, without the need to use relatively more expensive sources (having the full irradiance range needed for calibration and curing) for the entire width of the plate.

Although sources 421a and 421b are depicted schematically, it should be understood that each typically comprises a plurality of LED point sources and that while sources 421a and 421b are independently controllable, the point sources therein may also each be independently controllable, modularly controllable in a plurality of subsets or modules within each source 421a and 421b, with each subset or module having independent control, or the respective pluralities of point sources may be controllable as a whole within each source 421a and 421b, respectively.

In each of the various arrangements, after the calibration measurement has been made, the reading is compared to the target value that is usually expected for the specific type of photopolymer plate to be cured. If the result deviates from the expected target value, the setting for the backside exposure (curing) source is adjusted accordingly. This can be done by adjusting the backside exposure time if, for example, the intensity of the radiation is fixed. Alternatively, the irradiation intensity can be adjusted.

In practice, the photopolymer is not completely cured from the backside, because otherwise no printing relief structure would remain on the plate. Usually curing from the backside is stopped after 50 - 70 % of the photopolymer has been cured. The remaining non-cured polymer is then cured through the mask from the front side to create the relief structure.

It should be understood that the invention is not limited to any particular physical embodiment, and that the method of the invention of incorporating an optimized delay between back side and front side exposure may be performed in any system having any physical configuration.

Although the invention is illustrated and described herein with reference to specific embodiments, the invention is not intended to be limited to the details shown. Rather, various modifications may be made in the details within the scope and range of equivalents of the claims and without departing from the invention.

While preferred embodiments of the invention have been shown and described herein, it will be understood that such embodiments are provided by way of example only. Numerous variations, changes and substitutions will occur to those skilled in the art without departing from the spirit of the invention. Accordingly, it is intended that the appended claims cover all such variations as fall within the spirit and scope of the invention.

**Claims**

1. A method for automatically calibrating back exposure settings for a batch of photopolymer printing plate precursors, each plate precursor comprising a backing layer, a photopolymer layer comprising a photosensitive polymer activated by exposure to actinic radiation, and a front mask layer, the backing layer of plates in the batch having an unknown concentration of actinic radiation blockers, the method comprising the steps of:

   (a) removing a portion of the front mask layer;
   (b) positioning at least one photosensor, optionally comprising a plurality of photosensors each positioned a lateral distance relative to one another, on one side of the plate precursor aligned with the removed portion of the mask layer;
   (c) exposing the plate precursor to actinic radiation from the side of the plate precursor opposite the photosensor, via one or more radiation sources operating at a first setting;
   (d) measuring the actinic radiation power that reaches the photosensor through the plate precursor;
   (e) comparing the measured actinic radiation power with a target actinic radiation power value expected to be received for the plate precursor for the radiation source operating at the first setting; and
   (f) calculating from the measured actinic radiation power and the target actinic radiation power value a second setting for the one or more radiation sources suitable to reach a desired floor thickness of a finished printing plate formed from the plate precursor receiving the actinic radiation from the one or more radiation sources.

2. The method of claim 1, wherein the one or more actinic radiation sources include at least one front source positioned to expose a front side of the plate, at least one back source positioned to expose the back side of the plate, or a combination thereof, and further comprising commencing irradiating the front side of the printing plate after steps (d) - (f).

3. The method of claim 2, wherein the at least one back radiation source has an irradiation field covering an area at least coextensive with a width of the plate but not coextensive with a length of the plate, and step (f) comprises adjusting the floor thickness of the finished printing plate by providing one or more back-side-only exposure steps, each back-side-only exposure step comprising providing relative movement between the plate precursor and the at least one back radiation source.

4. The method of claims 1-3, further comprising exposing the plate to the actinic radiation via the one or more radiation sources over a total plate exposure time ($tc$).

5. The method of claim 4, wherein step (c) is performed for a predetermined period $tm$, and the predetermined period $tm$ is less than the total plate exposure time ($tc$).

6. The method of claim 4, further comprising repeating step (d) - (f) for a predetermined number of times

7. The method of claim 6, wherein the second setting comprises an exposure intensity setting for the one or more radiation sources, the exposure intensity setting being calculated as a factor to be applied to a first exposure intensity setting calculated to reduce a difference between the measured power and the target power.

8. The method of claim 1, wherein step (f) comprises calculating an average correction factor based on the measured power from the plurality of photosensors.

9. The method of claims 2 or 3, wherein step (c) comprises exposing the plate to the actinic radiation via the at least one back radiation source operating at a respective exposure intensity that is higher than the curing exposure intensity for an amount of time that is shorter than a total plate exposure time ($tc$).

10. The method of claim 9, wherein the back-side exposure in step (c) is applied only to an opening of the front mask layer created by step (a).

11. The method of claim 9, wherein the back-side exposure in step (c) is applied to an entirety of a surface of the plate.

12. The method of steps 9 or 10, wherein the at least one back radiation source operating at the higher respective exposure intensity in step (c) is a different back radiation source than a back radiation source configured for providing the curing exposure intensity.

13. The method of claim 1, wherein the front mask layer comprises a laser-ablated mask system (LAMS) layer, and wherein step (a) comprises removing the portion of the front mask layer by laser ablation.

14. The method of claim 12, wherein the front mask layer comprises a film.

15. A system for automatically calibrating back exposure settings for a batch of photopolymer printing plates, each photopolymer printing plate precursor comprising a backing layer, a photopolymer layer, and a front mask layer, the backing layer of plates in the batch having an unknown concentration of actinic radiation blockers, the system comprising:

   a plate holder configured to receive a plate precursor;
   one or more radiation sources including at least one front radiation source positioned to expose a front side of the plate to radiation, and at least one back radiation source positioned to expose a back side of the plate to radiation;
   a photosensor positioned to receive actinic radiation from at least one of the one or more front and back radiation sources transmitted through a plate precursor disposed on the plate holder;
   a controller connected to the one or more front and back radiation sources, the controller configured to: commence irradiation of the plate precursor from a side of the plate opposite the photosensor; measure actinic radiation power that reaches the photosensor through the plate precursor; compare the measured actinic radiation power with a target actinic radiation power value expected to be received for the plate precursor irradiated with the at least one of the one or more front and back radiation sources with the system operating at a first setting; and calculate from the measured power and the target power value a second setting suitable to reach a desired floor thickness of a finished printing plate resulting from back exposure of the plate precursor with the system at the second setting.

16. The system of claim 15, wherein the at least one back radiation source comprises a first radiation source having a first area and configured to provide back radiation at a first intensity predetermined for a curing operation, and a second radiation source having a second area smaller than the first area and configured to provide back radiation at a second intensity greater than the first intensity and predetermined for automatic calibration of the back exposure settings.

17. The system of claim 16, wherein second radiation is configured to operate at the first intensity and the second intensity, and the controller is configured to cause operation of the second radiation source at the first intensity during a curing operation and the second intensity during a calibration operation.

FIG. 1

FIG. 2

EP 4 575 642 A1

FIG. 3

EP 4 575 642 A1

FIG. 4A

FIG. 4B

FIG. 4C

FIG. 4D

FIG. 5

# FIG. 6

1010 — Remove a portion of a front mask layer of a printing plate precursor

1020 — Position a photosensor on one side of the plate precursor aligned with the removed portion of the mask layer

1030 — Expose the plate precursor to actinic radiation from the side of the plate opposite the photosensor, via one or more radiation sources operable at a first setting

1040 — Measure the actinic radiation that reaches the photosensor through the plate precursor

1050 — Compare the measured actinic radiation with a target power value expected for the plate precursor

1060 — Calculate from measured actinic radiation power and target actinic radiation power value a second setting for actinic radiation suitable to reach desired floor thickness of a finished printing plate formed from the plate precursor receiving the actinic radiation from the one or more radiation sources

1000

## EUROPEAN SEARCH REPORT

Application Number

EP 23 21 8034

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/276568 A1 (LENSSENS PIETER [BE] ET AL) 1 September 2022 (2022-09-01) * the whole document * ----- | 1-15 | INV.<br>G03F7/20<br>G03F7/00 |
| A | US 2023/367222 A1 (LENSSENS PIETER [BE] ET AL) 16 November 2023 (2023-11-16) * the whole document * ----- | 1-15 | |

**TECHNICAL FIELDS SEARCHED (IPC)**

G03F

The present search report has been drawn up for all claims

| Place of search | Date of completion of the search | Examiner |
|---|---|---|
| Munich | 1 October 2024 | Meixner, Matthias |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
....................................................................
& : member of the same patent family, corresponding
   document

EPO FORM 1503 03.82 (P04C01)

Europäisches
Patentamt

European
Patent Office

Office européen
des brevets

Application Number

EP 23 21 8034

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

[X] No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

**EP 4 575 642 A1**

## ANNEX TO THE EUROPEAN SEARCH REPORT
## ON EUROPEAN PATENT APPLICATION NO.

EP 23 21 8034

This annex lists the patent family members relating to the patent documents cited in the above-mentioned European search report.
The members are as contained in the European Patent Office EDP file on
The European Patent Office is in no way liable for these particulars which are merely given for the purpose of information.

01-10-2024

| Patent document cited in search report | Publication date | Patent family member(s) | Publication date |
|---|---|---|---|
| US 2022276568 A1 | 01-09-2022 | BR 112022000946 A2 | 22-03-2022 |
| | | CN 114424123 A | 29-04-2022 |
| | | EP 3999911 A1 | 25-05-2022 |
| | | JP 2022540827 A | 20-09-2022 |
| | | US 2022276568 A1 | 01-09-2022 |
| | | WO 2021013627 A1 | 28-01-2021 |
| US 2023367222 A1 | 16-11-2023 | CN 116547606 A | 04-08-2023 |
| | | EP 4222559 A1 | 09-08-2023 |
| | | JP 2023544280 A | 23-10-2023 |
| | | NL 2026610 B1 | 03-06-2022 |
| | | US 2023367222 A1 | 16-11-2023 |
| | | WO 2022069767 A1 | 07-04-2022 |

EPO FORM P0459

For more details about this annex : see Official Journal of the European Patent Office, No. 12/82

23

**REFERENCES CITED IN THE DESCRIPTION**

**Patent documents cited in the description**

- US 8389203 B
- US 8578854 B
- US 10732507 B
- US 626849
- US 20220276568 A1
- EP 3794411 B1